# EUROPÄISCHE PATENTANMELDUNG

(11) **EP 1 835 552 A1**
(43) Veröffentlichungstag der Anmeldung: **19.09.2007**
(21) Anmeldenummer: 06400011.0
(22) Anmeldetag: 17.03.2006
(51) Int. Cl.: H01L 41/04

(54) **Piezoelektrische Vorrichtung**

(71) Anmelder: Festo AG & Co., 73734 Esslingen (DE)
(72) Erfinder: Weinmann, Michael, Dr.-Ing., 73655 Plüderhausen (DE); Schmid, Andreas, Dr.-Ing., 96450 Coburg (DE); Fuss, Martin, Dipl.-Ing., 73240 Wendlingen (DE); Giousouf, Metin, Dipl.-Ing., 73732 Esslingen (DE); Szenn, Otto, Dr.-Ing., 71229 Leonberg (DE)
(74) Vertreter: Abel, Martin

(57) **Zusammenfassung**

Es wird eine piezoelektrische Vorrichtung vorgeschlagen, bei der es sich beispielsweise um einen Aktuator oder um einen Sensor handelt. Sie umfasst mindestens einen Piezowandler (4), der mit mindestens einer elektronischen Schaltung (5) bestückt ist. Diese mindestens eine elektronische Schaltung (5) ist zumindest teilweise aus intrinsisch leitfähigem organischem Polymermaterial aufgebaut. Damit verbunden ist eine besonders einfache Herstellung der piezoelektrischen Vorrichtung.

## Beschreibung

Die Erfindung betrifft eine piezoelektrische Vorrichtung, insbesondere Aktuator, Sensor oder Energiegenerator, mit mindestens einem Piezowandler, der mit mindestens einer elektronischen Schaltung bestückt ist.

Die WO 01/89004 A1 beschreibt eine im Zusammenhang mit einem Piezoventil zum Einsatz kommende piezoelektrische Vorrichtung der vorgenannten Art, die einen als Biegeelement ausgebildeten Piezowandler umfasst, der durch Anlagen einer Spannung quer zu seiner Längsachse auslenkbar ist. Das elektronische Management für die Aktivierung des Piezowandlers enthält dabei eine elektronische Schaltung, die unmittelbar auf oder in dem Piezowandler angeordnet ist. Durch diese Integration elektronischer Komponenten in den Piezowandler vereinfacht sich die Installation beim Zusammenbau der zugehörigen piezoelektrischen Vorrichtung, und auch der Platzbedarf kann im Vergleich zu extern platzierten Elektroniken verringert werden. Allerdings ist die Herstellung solcher integrierten Systeme bisher noch relativ aufwändig. Die hier zu Anwendung gelangenden Verfahren und Aufbautechniken der Mikroelektronik erfordern einen relativ hohen prozesstechnischen Aufwand.

Es ist die Aufgabe der vorliegenden Erfindung, eine einfach und kostengünstig herstellbare und im Betrieb dennoch funktionssichere piezoelektrische Vorrichtung zu schaffen.

Zur Lösung dieser Aufgabe ist bei einer piezoelektrischen Vorrichtung der eingangs genannten Art die mindestens eine an oder in dem Piezowandler angeordnete mindestens eine elektronische Schaltung zumindest teilweise aus intrinsisch leitfähigem organischem Polymermaterial aufgebaut.

Intrinsisch leitfähige Polymermaterialien sind Polymere, die einen elektrischen Strom ohne Zusatz leitfähiger, anorganischer Stoffe leiten. Die Leitfähigkeit kann dabei auf uneingeschränkt leitenden und/oder auf halbleitenden Eigenschaften der Polymere basieren. Beispiele für solche Polymermaterialien sind Polyanilin, Polythiophene oder Polypyrrol. Die Leitfähigkeit derartiger organische Polymere ist zwar in der Regel geringer als diejenige von Metallen oder Halbleitern, beispielsweise Silizium, wie sie bisher in der Mikrosystemtechnik zum Aufbau elektronischer Schaltungen zum Einsatz gelangen. Wie sich jedoch herausgestellt hat, ist die zur Verfügung gestellte intrinsische Leitfähigkeit dieser Polymere ausreichend, um die in Verbindung mit Piezowandlern erforderlichen elektronischen Schaltungen funktionsgerecht zu realisieren. Ein besonderer, damit verbundener Vorteil ist die Aufbringungsmöglichkeit der Schaltungskomponenten mit einfachen Auftrageverfahren, beispielsweise durch Drucken im Offsetdruck oder im Siebdruck. Das Schaltungslayout kann dabei relativ einfach an einem Computer entworfen werden. Somit ergibt sich eine äußerst hohe Flexibilität zur Realisierung unterschiedlichster Schaltungslayouts, was auch bei geringen Stückzahlen eine rationelle und kostengünstige Fertigung verspricht. Da das Polymermaterial in der Regel auch über flexible Eigenschaften verfügt, sind zudem der Auswahl des Platzierungsortes am Piezowandler praktisch keine Grenzen gesetzt. Das Polymermaterial kann die im Betrieb eventuell auftretenden Verformungen des Piezowandlers ohne Weiteres mitmachen, so dass sich die entsprechende elektronische Schaltung insbesondere auch zur Bestückung piezoelektrischer Biegeelemente eignet, die im Betrieb eine relativ starke Querauslenkung erfahren.

Vorteilhafte Weiterbildungen der Erfindung gehen aus den Unteransprüchen hervor.

Der Piezowandler kann mit einer oder mehreren elektronischen Schaltungen bestückt sein. Mindestens eine dieser elektronischen Schaltungen besteht dabei zumindest teilweise aus intrinsisch leitfähigem organischem Polymermaterial. Zweckmäßigerweise wird man aber sämtliche auf oder in dem Piezowandler vorgesehenen elektronischen Schaltungen entsprechend ausführen.

Vorzugsweise besteht mindestens eine elektronische Schaltung, mit der der Piezowandler bestückt ist, insgesamt aus Polymermaterial. Diejenigen Bereiche der elektronischen Schaltung, die aus schaltungstechnischer Sicht nicht leitfähig sein sollen, bestehen in diesem Fall aus einem Polymermaterial mit elektrisch isolierenden Eigenschaften, beispielsweise Polyester oder Polymethylmethacrylat (PMMA). In diesem Fall können alle elektronischen Schaltungskomponenten durch ein entsprechendes Polymerlayout, insbesondere in mehrschichtigem Aufbau, realisiert werden.

Grundsätzlich besteht allerdings auch die Möglichkeit, die elektronische Schaltung zusätzlich mit mindestens einem klassischen, diskreten elektronischen Bauelement auszustatten, beispielsweise ein ohmsches Widerstandselement, ein induktives Spulenelement und/oder ein integriertes Halbleiter-Chipelement.

Die elektronische Schaltung hat zweckmäßigerweise eine flächenhafte Gestalt und kann daher so großflächig auf der Außenfläche des Piezowandlers platziert werden, ohne dessen Dickenabmessungen nennenswert zu vergrößern.

Im einfachsten Fall ist die elektronische Schaltung ganzflächig an dem Piezowandler befestigt. Sie kann beispielsweise aufgedruckt oder, insbesondere unter Zwischenschaltung einer Trägerfolie, aufgeklebt sein.

Eine vorteilhafte Möglichkeit sieht eine nur teilweise Befestigung der elektronischen Schaltung am Piezowandler vor, wobei mindestens ein vom Piezowandler wegragender flexibler Schaltungsabschnitt verbleibt, der bezüglich dem Piezowandler beweglich sein kann und insbesondere streifenartig gestaltet ist. Er kann zur Verbindung mit einer anderen elektronischen Einrichtung genutzt werden oder auch als Träger für eine elektronische Komponente, insbesondere für ein Leuchtanzeigeelement. Im letzteren Fall ist vorzugsweise eine organische Leuchtdiode (OLED) vorgesehen.

Der Piezowandler verfügt - je nach Einsatzzweck zum Anlegen oder Abgreifen einer Spannung - über mindestens eine und in der Regel wenigstens zwei Elektroden. Es ist von Vorteil, wenn mindestens eine dieser Elektroden ebenfalls aus intrinsisch leitfähigem organischem Polymermaterial besteht. Bei einer bevorzugten Ausführungsform ist diese Elektrode auf den Piezowandlerkörper aufgedruckt.

Die mindestens eine elektronische Schaltung kann eine oder mehrere Funktionen bezüglich dem Piezowandler ausüben. Insbesondere definiert sie eine Ansteuerelektronik für den Piezowandler, die eine Spannungswandlerschaltung und/oder eine Strombegrenzungsschaltung und/oder eine Lade/Entladeschaltung für den Piezowandler bildet. Wird die piezoelektrische Vorrichtung nicht als Aktuator, sondern als Sensor eingesetzt, der entsprechend seiner Verformung ein elektrisches Signal erzeugt, kann die elektronische Schaltung auch eine Auswerteelektronik bilden.

Die piezoelektrische Vorrichtung ist unter Ausnutzung des direkten piezoelektrischen Effektes auch als Energiegenerator einsetzbar. Aus einer hervorgerufenen Verformung des Piezowandlers resultiert eine abgreifbare Spannung, so dass ein Verbraucher oder Akkumulator gespeist werden kann.

Für den Piezowandler kommen unterschiedliche Konstruktionskonzepte in Frage. Er kann beispielsweise als Stapeltranslator oder als Biegeelement ausgebildet sein. In der Regel wird er über einen mehrschichtigen Aufbau verfügen. Insbesondere in Verbindung mit einem Biegeelement ist es von Vorteil, wenn die elektronische Schaltung in der neutralen Faserschicht des Biegeelementes platziert ist, um die Beanspruchung der Bestandteile der elektronischen Schaltung so niedrig wie möglich zu halten.

Eine bevorzugte Einsatzmöglichkeit der erfindungsgemäßen piezoelektrischen Vorrichtung ist diejenige einer Betätigungsvorrichtung eines Piezoventils. Der Piezowandler kann dabei ein Betätigungselement bilden, das ein Ventilglied antreibt oder unmittelbar bildet. Die Einsatzmöglichkeiten der piezoelektrischen Vorrichtung sind jedoch auf diesen Anwendungsfall nicht beschränkt.

Nachfolgend wird die Erfindung anhand der beiliegenden Zeichnung näher erläutert. In dieser zeigen:
- Figur 1: einen bevorzugten Aufbau der erfindungsgemäßen piezoelektrischen Vorrichtung in perspektivischer Darstellung im Zusammenhang mit einem Einsatz als Ventilglied eines Piezoventils, wobei ein vergrößerter Ausschnitt einen bevorzugten Schichtaufbau des Piezowandlers in einer Schnittdarstellung wiedergibt,
- Figur 2: einen Längsschnitt durch eine weitere Ausführungsform der piezoelektrischen Vorrichtung,
- Figur 3: erneut ein weiteres Ausführungsbeispiel der piezoelektrischen Vorrichtung im Längsschnitt und
- Figur 4: eine erfindungsgemäße piezoelektrische Vorrichtung, deren Piezowandler als Stapeltranslator ausgeführt ist, im Gegensatz zu der Ausführung als Biegeelement im Falle der Figuren 1 bis 3.

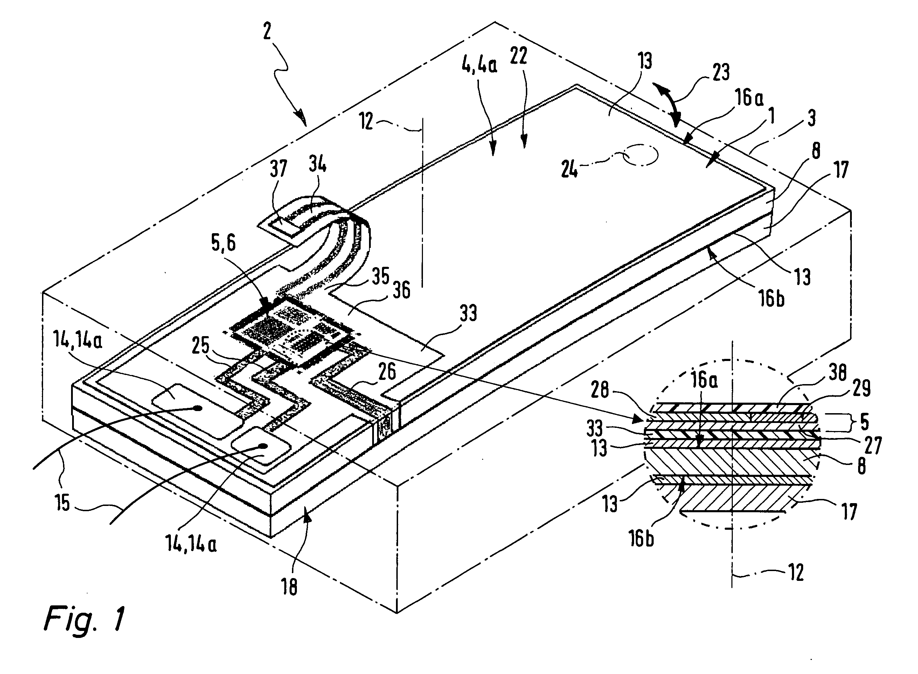

Die Figur 1 zeigt insgesamt in schematischer Weise eine Anwendungsmöglichkeit für die mit Bezugsziffer 1 versehene piezoelektrische Vorrichtung, und zwar im Zusammenhang mit einem elektrisch aktivierbaren Piezoventil 2. Die piezoelektrische Vorrichtung 1 bildet dabei die Betätigungsvorrichtung des Piezoventils 2. Letzteres enthält ein strichpunktiert angedeutetes Gehäuse 3, an dem die piezoelektrische Vorrichtung 1 so fixiert ist, dass sie in den Innenraum des Gehäuses 3 hineinragt.

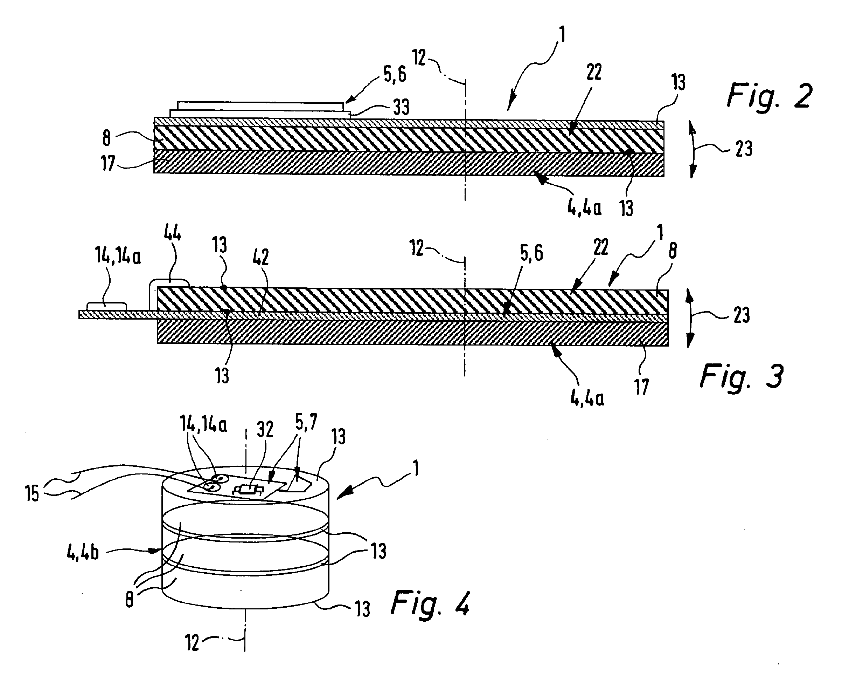

Die piezoelektrische Vorrichtung 1 - die Figuren 2 bis 4 zeigen alternative Bauformen derselben - enthält mindestens einen - bei den Ausführungsbeispielen jeweils genau einen - Piezowandler 4. Dieser wird je nachdem, ob die piezoelektrische Vorrichtung 1 wie im Falle der Figuren 1 bis 3 als Aktuator oder wie im Falle der Figur 4 als Sensor oder Energiegenerator eingesetzt wird, unter Ausnutzung des sogenannten inversen piezoelektrischen Effektes oder des direkten piezoelektrischen Effektes betrieben. Der inverse, auch als reziproker piezoelektrischer Effekt bezeichnete Effekt äußert sich in einer Dickenänderung eines piezoelektrischen Werkstoffes bei Anlegen einer elektrischen Spannung. Beim direkten piezoelektrischen Effekt wird durch die Verformung eines piezoelektrischen Materials eine elektrische Polarisation hervorgerufen, woraus eine abgreifbare Spannung resultiert.

Unabhängig davon, auf welchem Effekt der Einsatz des Piezowandlers resultiert, kann er unterschiedlich konzipiert sein. In den Fällen der Figuren 1 bis 3 ist er ein Biegeelement 4a, oft auch als Biegewandler bezeichnet, während er im Falle der Figur 4 als Stapeltranslator 4b ausgebildet ist.

Allen Ausführungsbeispielen ist gemeinsam, dass der Piezowandler 4 mit mindestens einer elektronischen Schaltung 5 bestückt ist. Der Piezowandler 4 trägt also unmittelbar selbst die elektronische Schaltung 5, die mit ihm zu einer die piezoelektrische Vorrichtung bildenden Baueinheit zusammengefasst ist. Beim Ausführungsbeispiel der Figuren 1 bis 3 trägt der Piezowandler 4 jeweils nur eine elektronische Schaltung 5, im Falle der Bauform der Figur 4 ist er mit zwei elektronischen Schaltungen 5 ausgestattet, die jedoch zweckmäßigerweise direkt am Piezowandler 4 elektrisch miteinander verschaltet sind.

Die mindestens eine elektronische Schaltung 5 kann eine oder mehrere Aufgaben übernehmen. Exemplarisch bildet sie im Falle der Figuren 1 bis 3 eine Ansteuerelektronik 6 für den mit ihr ausgestatteten Piezowandler 4, wobei sie eine Spannungswandlerschaltung und/oder eine Strombegrenzungsschaltung und/oder eine Lade-/Entladeschaltung für den Piezowandler 4 umfassen kann. Die Spannungswandlerschaltung konvertiert eine angelegte Eingangsspannung auf die gewünschte Ansteuerspannung für den Piezowandler 4, wobei insbesondere eine Spannungserhöhung in Frage kommt. Eine Strombegrenzungsschaltung kann Beschädigungen der Piezocharakteristik durch Überbeanspruchung verhindern. Eine Lade-/Entladeschaltung wird insbesondere bei einem Zweidrahtbetrieb eingesetzt, um die zum Rückstellen der Verformung des Piezowandlers erforderliche elektrische Entladung zu ermöglichen.

Bei dem Ausführungsbeispiel der Figur 4 definieren die elektronischen Schaltungen 5 eine Auswerteelektronik 7. Diese ist in der Lage, die durch eine Verformung des Piezowandlers 4 hervorgerufene Spannungsänderung auszuwerten und beispielsweise in ein unmittelbar zur Anzeige aufgetretener Verformungen nutzbares elektrisches Signal umzuwandeln.

Andere als die geschilderten Ausführungsformen der elektronischen Schaltungen 5 sind selbstverständlich ebenfalls möglich und orientieren sich am jeweiligen Bedarf. Auch besteht die Möglichkeit, ein und denselben Piezowandler 4 sowohl mit einer Ansteuerelektronik 6 als auch mit einer Auswerteelektronik 7 auszustatten. Beispielsweise kann über die elektronische Schaltung 5 sowohl die Verformung des Piezowandlers 2 koordiniert werden als auch die Auswertung der aus dem Anlegen der Ansteuerspannung resultierenden Verformung als Stellungssignal.

Ungeachtet ihrer konkreten Ausgestaltung enthalten die Piezowandler 4 einen oder mehrere aus Piezomaterial bestehende Körper 8, die im Folgenden der Einfachheit halber nur als Piezokörper bezeichnet werden. Bei diesem piezoelektrischen Material handelt es sich beispielsweise um eine Sinterkeramik, insbesondere eine Blei-Zirkonat-Titanat-Verbindung (PZT), dem das piezoelektrische Verhalten während des Herstellungsvorganges durch Anlegen eines starken elektrischen Feldes eingeprägt wird. Die Piezokörper 8 sind insbesondere plattenförmig - wie exemplarisch in Figuren 1 bis 3 gezeigt - oder scheibenförmig - wie exemplarisch in Figur 4 gezeigt - ausgebildet.

Bei sämtlichen Ausführungsbeispielen sind die Piezokörper 8 als monolithische Komponenten ausgeführt. Sie könnten aber ebenso zumindest teilweise auch als Mehrschicht-Piezokörper konzipiert sein, in welchem Falle man von einem Multilayer-Aufbau sprechen würde.

Ein gemäß Figur 4 konzipierter Stapeltranslator 4b enthält mehrere in Richtung einer Schichtungsachse 12 aufeinander geschichtete platten- oder scheibenförmige Piezokörper 8, deren Ausdehnungsebenen rechtwinkelig zu der Schichtungsachse 12 verlaufen. Jeder Piezokörper 8 ist in Richtung der Schichtungsachse 12 beidseits von einer Elektrode 13 flankiert. Diese Elektroden 13 sind über nicht näher gezeigte elektrische Leiter an die elektronische Schaltung 5 angeschlossen, die mit Anschlussmitteln 14 für abgehende elektrische Leiter 15 verbunden ist. Bei einer in Richtung der Schichtungsachse 12 auftretenden Belastung des Stapeltranslators 4b treten zwischen den einen jeweiligen Piezokörper 8 flankierenden Elektroden 13 elektrische Spannungen auf, die in der an Bord des Piezowandlers 4 befindlichen elektronischen Schaltung 5 ausgewertet werden, um daraus resultierend über die Anschlussmittel 14 und die elektrischen Leiter 15 geeignete Spannungssignale auszugeben.

Bei den Ausführungsbeispielen der Figuren 1 bis 3 enthält der als Biegeelement 4a konzipierte Biegewandler 4 einen einzigen, plattenförmigen Piezokörper 8, der hier insbesondere streifen- oder lamellenförmig gestaltet ist und mithin eine längliche Gestalt besitzt, zweckmäßigerweise mit einem ungleiche Seitenlängen aufweisenden rechteckigen Grundriss. Dieser Piezokörper 8 ist an seinen beiden großflächigen Außenflächen von je einer Elektrode 13 flankiert, die zumindest den größten Teil der beiden großflächigen Außenflächen 16a, 16b belegen kann.

In Richtung einer zur Ausdehnungsebene des plattenförmigen Piezokörpers 8 rechtwinkeligen Schichtungsachse 12 ist benachbart zu der einen großflächigen Außenfläche 16b ein bevorzugt den gleichen Grundriss wie der Piezokörper 8 aufweisender Piezowandlerkörper 17 angeordnet. Er ist ganzflächig mit dem benachbarten Piezokörper 8 verbunden, beispielsweise durch eine Klebeverbindung. Beim Ausführungsbeispiel bildet er einen einfachen Trägerkörper für den benachbarten Piezokörper 8, der im Betrieb der piezoelektrischen Vorrichtung 1 piezoelektrisch inaktiv bleibt. Es kann sich um einen Anpasskörper handeln, der aus einem nicht piezoelektrischen Material besteht und in der Materialwahl so auf das Gesamtprodukt abgestimmt ist, dass rein temperaturbedingte Verformungen des Piezowandlers 4 ausgeschlossen sind.

Abweichend von dieser Bauform könnte der Piezowandlerkörper 17 allerdings auch ein im Betrieb aktivierbarer Piezokörper sein, beispielsweise um einen Bimorph-Piezowandler zu realisieren, der in zwei Richtungen auslenkbar ist.

Im betriebsbereiten Zustand ist das Biegeelement 4a in der Regel an einem als Befestigungsabschnitt 18 ausgebildeten Endabschnitt ortsfest fixiert. Beim Ausführungsbeispiel kann es in dem entsprechend ausgebildeten Gehäuse 3 eingespannt sein. Ausgehend von diesem eingespannten Befestigungsabschnitt 18 kragt es mit einem Arbeitsabschnitt 22 frei endend weg. Bei Anlagen einer Ansteuerspannung an die Elektroden 13 erfährt der Piezokörper 8 eine Verformung, die auf Grund des sich nicht mitverformenden Piezowandlerkörpers 17 zu einer Auslenkung des Biegeelementes 4a im Bereich seines Arbeitsabschnittes 22 quer zur Ausdehnungsebene des Piezokörpers 8 führt. Die mögliche Auslenkbewegung ist bei 23 durch einen Doppelpfeil angedeutet.

Bildet die erfindungsgemäße Vorrichtung gemäß Figur 1 die Betätigungsvorrichtung eines Piezoventils 2, kann der Piezowandler 4 als Ventilglied fungieren, das je nach Stellung eine schematisch angedeutete Ventilöffnung 24 mehr oder weniger freigibt oder verschließt. Alternativ kann der Piezowandler 4 auch als reines Aktorelement fungieren, das ein gesondertes Ventilglied betätigt.

Zum Anlegen der erforderlichen Ansteuerspannung ist das Biegeelement 4a mit Anschlussmitteln 14 für wegführende elektrische Leiter 15 ausgestattet. Bei den Anschlussmitteln 14 handelt es sich insbesondere um flächenhafte Anschlusspads 14a. An diesen können die elektrischen Leiter 15, beispielsweise durch Anlöten, elektrisch angeschlossen werden.

Von den Anschlussmitteln 14 führen elektrische Leiter 25 zu der elektronischen Schaltung 5, von der wiederum, nur teilweise abgebildet, elektrische Leiter 26 zur Kontaktierung der Elektroden 13 abgehen. Die über die elektrischen Leiter 15 angelegte Betriebsspannung wird in der elektronischen Schaltung 5 in die erforderliche Ansteuerspannung für die Elektroden 13 konvertiert.

Als besonders vorteilhafte Maßnahme ist bei allen piezoelektrischen Vorrichtungen 1 vorgesehen, dass die elektronische Schaltung 5 zumindest teilweise aus intrinsisch leitfähigem organischem Polymermaterial besteht. Bei diesem Material handelt es sich beispielsweise um Polyanilin, Polythiophene oder Polypyrrol. Aus diesem Polymermaterial sind die leitfähigen Strukturen der elektronischen Schaltung gebildet, wobei im Falle der Bauformen der Figuren 1 bis 3 die gesamte elektronische Schaltung 5 aus einem Polymermaterial besteht. Die elektrisch leitfähigen Strukturen werden durch das intrinsisch leitfähige organische Polymermaterial gebildet, die nicht leitfähigen Strukturen aus einem elektrisch nichtleitenden, isolierenden Polymermaterial. Vorzugsweise wird auch bei dem über elektrisch isolierende Eigenschaften verfügenden Polymermaterial auf ein organisches Polymermaterial zurückgegriffen. Als elektrisch isolierende Polymere bieten sich vor allem Polyester oder Polymethylmethacrylat (PMMA) an.

Um das gewünschte Schaltungslayout zu erzielen, ist es in Verbindung mit der Einhaltung kompakter Abmessungen der piezoelektrischen Vorrichtung 1 von Vorteil, wenn die elektronische Schaltung 5 über eine flächenhafte Ausdehnung verfügt und mehrschichtig aufgebaut ist. Ein solcher Mehrschichtaufbau ist in der vergrößerten Schnittdarstellung der Figur 1 schematisch angedeutet. Man erkennt hier eine erste elektrisch leitende Schicht 27, auf der eine zweite elektrisch leitende Schicht 28 liegt und, in einer gemeinsamen Ebene mit letzterer, eine elektrisch nichtleitende Schicht 29. All diese Schichten bestehen aus Polymermaterial, die elektrisch leitenden Schichten 27, 28 dabei aus organischen Polymermaterial mit intrinsischer Leitfähigkeit. Die Leitfähigkeit dieser Polymere basiert auf der elektrischen Leitfähigkeit des Materials als solchem und nicht auf dem Zusatz leitfähiger, anorganischer Stoffe, wie z.B. der Einlagerung von Rußpartikeln oder anderer kohlenstoffhaltiger Komponenten. Bei den erwähnten intrinsisch leitfähigen Materialien basiert die elektrische Leitfähigkeit beispielsweise auf einer Protonierung.

In speziellen Fällen, beispielsweise wenn durch die bloße Strukturierung des Polymermaterials eine bestimmte Schaltungsfunktion nicht oder nur sehr schwierig realisierbar ist, kann die elektronische Schaltung zusätzlich auch mindestens ein diskretes elektronisches Bauelement 32 klassischer Bauart aufweisen, wie dies in Figur 4 angedeutet ist. Hier kann es sich beispielsweise um einen Mikrochip handeln, der durch Bonden oder andere Kontaktierungsverfahren mit dem leitfähigen organischen Polymermaterial kontaktiert ist.

Die elektrischen Leiter 25, 26 und/oder die Anschlussmittel 14 können im Übrigen ebenfalls aus einem intrinsisch leitfähigen organischen Polymermaterial bestehen. Gleiches gilt für die Elektroden 13.

Die elektronische Schaltung 5 kann beispielsweise durch ein Druckverfahren komplikationslos direkt auf den Piezowandler 4 aufgebracht werden. Beim Ausführungsbeispiel der Figur 4 ist dies der Fall. Alternativ kann die elektronische Schaltung 5 auch auf eine Trägerfolie 33 aufgebracht und insbesondere aufgedruckt werden, über die die Fixierung am Piezowandler 4 erfolgt. Diese Trägerfolie 33 besteht zweckmäßigerweise aus einem elektrisch isolierenden Material, insbesondere ebenfalls einem organischen Polymermaterial.

Bei dem Ausführungsbeispiel der Figur 1 ist die elektronische Schaltung 5 auf eine Trägerfolie 33 aufgebracht und zusammen mit dieser als Baueinheit am Piezowandler 4 fixiert. Die Trägerfolie 33 ist auf den Piezowandler 3 vorzugsweise aufgeklebt. Es kann sich um eine Selbstklebefolie handeln.

Bei dem Ausführungsbeispiel der Figur 2 erfolgt die Applikation am Piezowandler 4 in aufeinanderfolgenden Schritten. Hier ist zunächst die Trägerfolie 33 aufgebracht und anschließend auf diese die elektronische Schaltung 5, wobei sich letztere wiederum aus mehreren Schichten zusammensetzen kann, die in Figur 2 jedoch nicht im Einzelnen dargestellt sind.

Es ist vorteilhaft, wenn die gesamte elektronische Schaltung 5 an dem Piezowandler 4 befestigt ist. Beispielhaft können hierzu die Ausführungsformen 2 bis 4 genannt werden. Bei dem Ausführungsbeispiel der Figur 1 hingegen liegt eine Besonderheit insofern vor, als die elektronische Schaltung 5 einen bevorzugt flexiblen Schaltungsabschnitt 34 aufweist, der in einem Übergangsbereich 35 mit einem seinerseits vollflächig am Piezowandler 4 befestigten Basisabschnitt 36 der elektronischen Schaltung 5 verbunden ist. Über den Basisabschnitt 36 ist somit die elektronische Schaltung 5 mit lediglich einer Teilfläche am Piezowandler 4 befestigt.

Der flexible Schaltungsabschnitt 34 ist beim Ausführungsbeispiel streifenartig gestaltet. Er ist relativ zum Piezowandler 4 auf Grund elastischer Verformbarkeit beweglich und kann beispielsweise zur Ankopplung weiterer elektronischer Komponenten genutzt werden. Beispielsweise lässt sich über ihn eine weitere piezoelektrische Vorrichtung 1 kontaktieren, wenn ein Gerät gleichzeitig mit mehreren piezoelektrischen Vorrichtungen 1 ausgestattet ist. Ebenfalls möglich ist eine unmittelbare Ausstattung des flexiblen Schaltungsabschnittes 34 mit mindestens einem Leuchtanzeigeelement 37, das in der Lage ist, einen oder mehrere Schaltzustände der piezoelektrischen Vorrichtung 1 zu visualisieren. Bei der gezeigten Anwendung kann das Leichtanzeigeelement 37 beispielsweise im Bereich einer Aussparung des Gehäuses 3 platziert werden, so dass von außen her gewisse Schaltzustände durch Lichtsignale erkennbar werden.

Bei dem Leuchtanzeigeelement 37 handelt es sich vorzugsweise um eine organische Leuchtdiode (OLED).

Soweit die elektronische Schaltung 5 ganz oder teilweise in einem Druckverfahren aufgebracht wird, bietet sich insbesondere ein Siebdruckverfahren an. Prinzipiell wäre allerdings auch ein Offsetdruckverfahren möglich. Vorteilhaft ist jedenfalls, dass das gewünschte Schaltungslayout sehr einfach an einem Computer entworfen werden kann, wobei auf der Basis der dabei generierten Daten ein geeigneter Drucker ansteuerbar ist.

Bei den Ausführungsbeispielen der Figuren 1, 2 und 4 sitzt die elektronische Schaltung 5 an der Außenfläche des Piezowandlers 4. Gemäß Figur 4 kann sie bei einem Stapeltranslator 4b an einer der beiden in der Richtung der Schichtungsachse 12 orientierten Stirnflächen angeordnet sein, oder auch an beiden dieser Stirnflächen. Bei einem Biegeelement gemäß Figuren 1 und 2 bietet sich eine Platzierung an einer der beiden großflächigen Außenflächen 16a an. Je nach Ausgestaltung kann sich die elektronische Schaltung 5 dabei über nur einen Teil oder die Gesamtheit der großflächigen Außenfläche 16a erstrecken. Eine Platzierung im Bereich des Arbeitsabschnittes 22 ist unbedenklich, weil das Polymermaterial in der Regel über flexible Eigenschaften verfügt und somit die Verformungen des Piezowandlers 4 problemlos mitmachen kann.

Bei Bedarf können beide großflächigen Außenflächen 16a, 16b zur Bestückung mit einer oder mehreren elektronischen Schaltungen 5 herangezogen werden.

Gemäß dem vergrößerten Ausschnitt in Figur 1 kann sich über die elektronische Schaltung 5 bei Bedarf noch eine über elektrisch isolierende Eigenschaften verfügende Schutzschicht 38 erstrecken. Diese besteht wiederum zweckmäßigerweise aus einem Polymermaterial, vorzugsweise aus einem organischen Polymermaterial. Sie trägt dazu bei, die elektronische Schaltung 5 vor Umgebungseinflüssen zu schützen.

Aus Figur 3 wird deutlich, dass die elektronische Schaltung 5 auch im Innern des Piezowandlers 4 angeordnet sein kann. Exemplarisch befindet sie sich zwischen dem Piezokörper 8 und dem benachbarten Piezowandlerkörper 17. Zwischen diesen beiden Körpern 8, 17 erstreckt sich vorzugsweise eine Zwischenschicht 42, die insbesondere aus organischem Polymermaterial besteht, das jedoch zweckmäßigerweise elektrisch nichtleitend ist. Auf einer oder beiden Seitenflächen dieser Zwischenschicht 42 ist die elektronische Schaltung 5 aufgebracht. Die Zwischenschicht 42 kann ein Folienelement sein, das sich beim Zusammenbau des Piezowandlers 4 mit zuvor aufgebrachter elektronischer Schaltung 5 zwischen die beiden Körper 8, 17 des Piezowandlers 4 einlegen lässt.

Ein Endabschnitt 43 der Zwischenschicht 42 ragt seitlich, insbesondere stirnseitig nach außen über die beiden Körper 8, 17 vor und trägt die mit der elektronischen Schaltung 5 verbundenen Anschlussmittel 14. Die an der Außenseite des Piezokörpers 8 angeordnete Elektrode 13 ist über einen außen um den Rand des Piezokörpers 8 herumgeführten elektrischen Leiter 44 kontaktiert, oder alternativ über eine Durchkontaktierung. Die innere Elektrode 13 liegt bevorzugt zwischen der Zwischenschicht 42 und dem Piezokörper 8 und kann direkt in diesem Bereich mit der elektronischen Schaltung 5 oder einem mit dieser verbundenen elektrisch leitenden Bereich kontaktiert sein.

Die Anordnung der elektronischen Schaltung 5 zwischen den beiden Körpern 8, 17 hat zum einen den Vorteil eines automatischen Schutzes der elektronischen Schaltung 5 vor Umgebungseinflüssen, da diese nach außen hin abgeschottet ist. Ein weiterer Vorteil resultiert daraus, dass sich die elektronische Schaltung 5 hier ausschließlich im Bereich der neutralen Faserschicht des Biegeelementes 4a erstrecken kann, also in derjenigen Schicht, in der beim Verformen des Piezowandlers 4 weder Längsdehnungen noch Längsstauchungen auftreten. Dadurch sind die Komponenten der elektronischen Schaltung 5, ungeachtet der Flexibilität des Polymermaterials, besonders zuverlässig vor einer mechanischen Überbeanspruchung geschützt.

Die elektronische Schaltung 5 kann im Übrigen auch einen Transponder bilden, der im Zusammenhang mit der sogenannten RFID-Technik einsetzbar ist (RFID = Radio Frequeny Identification). Somit können in der elektronischen Schaltung die piezoelektrische Vorrichtung 1 betreffende spezifische Informationen gespeichert sein, beispielsweise Serviceinformationen, die bei Bedarf ausgelesen werden können, ohne dass eine Energieversorgung angeschlossen werden müsste. Zusätzlich oder alternativ kann aber auch eine Sende- und Empfangsantenne in die elektronische Schaltung einbezogen sein, welche eine aktive Kommunikation der piezoelektrischen Vorrichtung 1 mit anderen Komponenten, beispielsweise elektronischen Steuerungen, ermöglicht.

Schließlich besteht auch die Möglichkeit, die elektronische Schaltung so auszuführen, dass sie eine interne Entladung und somit ein Umschalten des Piezowandlers in seine unbedenkliche Grundstellung verursacht, wenn die angelegte Spannung, beispielsweise auf Grund eines Kabelschadens, unterbrochen wird.

Somit kann die elektronische Schaltung 5 auch eine Sicherheitsfunktion ausüben.

## Patentansprüche

1. Piezoelektrische Vorrichtung, insbesondere Aktuator, Sensor oder Energiegenerator, mit mindestens einem Piezowandler (4), der mit mindestens einer elektronischen Schaltung (5) bestückt ist, **dadurch gekennzeichnet, dass** die mindestens eine elektronische Schaltung (5) zumindest teilweise aus intrinsisch leitfähigem organischem Polymermaterial aufgebaut ist.

2. Vorrichtung nach Anspruch 1, **dadurch gekennzeichnet, dass** die mindestens eine elektronische Schaltung (5) insgesamt aus Polymermaterial, vorzugsweise aus organischem Polymermaterial, besteht.

3. Vorrichtung nach Anspruch 1, **dadurch gekennzeichnet, dass** die mindestens eine elektronische Schaltung (5) auch mindestens ein klassisches, diskretes elektronisches Bauelement (32) aufweist.

4. Vorrichtung nach einem der Ansprüche 1 bis 3, **dadurch gekennzeichnet, dass** die mindestens eine elektronische Schaltung (5) eine flächenhafte Gestalt aufweist.

5. Vorrichtung nach Anspruch 4, **dadurch gekennzeichnet, dass** die elektronische Schaltung (5) ganzflächig an dem Piezowandler (4) befestigt ist.

6. Vorrichtung nach Anspruch 4, **dadurch gekennzeichnet, dass** die elektronische Schaltung (5) mit lediglich mindestens einer Teilfläche (36) an dem Piezowandler (4) befestigt ist und darüber hinaus mindestens einen vom Piezowandler (4) wegragenden flexiblen Schaltungsabschnitt (34) aufweist.

7. Vorrichtung nach Anspruch 6, **dadurch gekennzeichnet, dass** der flexible Schaltungsabschnitt (34) relativ zum Piezowandler (4) beweglich ist.

8. Vorrichtung nach Anspruch 6 oder 7, **dadurch gekennzeichnet, dass** der flexible Schaltungsabschnitt (34) streifenartig gestaltet ist.

9. Vorrichtung nach einem der Ansprüche 6 bis 8, **dadurch gekennzeichnet, dass** der flexible Schaltungsabschnitt (34) mindestens ein Leuchtanzeigeelement (37) aufweist, insbesondere mindestens eine organische Leuchtdiode.

10. Vorrichtung nach einem der Ansprüche 1 bis 9, **dadurch gekennzeichnet, dass** es sich bei dem intrinsisch leitfähigen Polymermaterial um Polyanilin und/oder Polythiophene und/oder Polypyrrol handelt.

11. Vorrichtung nach einem der Ansprüche 1 bis 10, **dadurch gekennzeichnet, dass** die mindestens eine elektronische Schaltung (5) einen mehrschichtigen Aufbau besitzt.

12. Vorrichtung nach einem der Ansprüche 1 bis 11, **dadurch gekennzeichnet, dass** die mindestens eine elektronische Schaltung (5) für das Anlegen und/oder Abgreifen einer Spannung über aus intrinsisch leitfähigem organischem Polymermaterial bestehende Anschlussmittel (14) verfügt, insbesondere mindestens ein flächenhaftes Anschlusspad (14a).

13. Vorrichtung nach einem der Ansprüche 1 bis 12, **dadurch gekennzeichnet, dass** die mindestens eine elektronische Schaltung (5), insbesondere durch Siebdruck, direkt auf den Piezowandler (4) oder auf eine am Piezowandler befestigte Trägerfolie (33) oder Zwischenschicht (42) aufgedruckt ist.

14. Vorrichtung nach einem der Ansprüche 1 bis 13, **dadurch gekennzeichnet, dass** der Piezowandler (4) mindestens eine mit der elektronischen Schaltung (5) kontaktierte Elektrode (13) aufweist, die aus intrinsisch leitfähigem organischem Polymermaterial besteht.

15. Vorrichtung nach Anspruch 14, **dadurch gekennzeichnet, dass** die mindestens eine Elektrode auf einen Körper (8, 17) des Piezowandlers (4) aufgedruckt ist.

16. Vorrichtung nach einem der Ansprüche 1 bis 15, **dadurch gekennzeichnet, dass** die mindestens eine elektronische Schaltung (5) zu einer Ansteuerelektronik (6) und/oder einer Auswerteelektronik (7) für den Piezowandler (4) gehört oder eine solche bildet.

17. Vorrichtung nach einem der Ansprüche 1 bis 16, **dadurch gekennzeichnet, dass** die mindestens eine elektronische Schaltung (5) eine Spannungswandlerschaltung und/oder eine Strombegrenzungsschaltung und/oder eine Lade-/Entladeschaltung für den Piezowandler (4) bildet.

18. Vorrichtung nach einem der Ansprüche 1 bis 17, **dadurch gekennzeichnet, dass** mindestens ein Piezowandler (4) als Stapeltranslator (4b) ausgebildet ist.

19. Vorrichtung nach einem der Ansprüche 1 bis 18, **dadurch gekennzeichnet, dass** mindestens ein Piezowandler (4) als Biegeelement (4a) ausgebildet ist.

20. Vorrichtung nach Anspruch 19, **dadurch gekennzeichnet, dass** die elektronische Schaltung (5) in der beim Verbiegen des Biegeelementes (4a) keine Längsdehnungen und Längsstauchungen erfahrenden neutralen Faserschicht des Biegeelementes (4a) platziert ist.

21. Vorrichtung nach einem der Ansprüche 1 bis 20, **dadurch gekennzeichnet, dass** die elektronische Schaltung einen Transponder zur Verwendung bei einer RFID-Technologie bildet.

22. Vorrichtung nach einem der Ansprüche 1 bis 21, **gekennzeichnet durch** eine Ausgestaltung als Betätigungsvorrichtung eines Piezoventils (2).
